Europäisches Patentamt

European Patent Office

Office européen des brevets

(11) Veröffentlichungsnummer: **0 351 691 B1**

(19)

## EUROPÄISCHE PATENTSCHRIFT

(45) Veröffentlichungstag der Patentschrift: **15.06.94**

(21) Anmeldenummer: **89112622.9**

(22) Anmeldetag: **11.07.89**

(51) Int. Cl.⁵: **H03B 5/08**

(54) **Rückgekoppelter Hochfrequenz-Leistungsoszillator.**

(30) Priorität: **22.07.88 DE 3824970**

(43) Veröffentlichungstag der Anmeldung:
**24.01.90 Patentblatt 90/04**

(45) Bekanntmachung des Hinweises auf die
Patenterteilung:
**15.06.94 Patentblatt 94/24**

(84) Benannte Vertragsstaaten:
**FR GB IT**

(56) Entgegenhaltungen:
**EP-A- 0 237 795**
**FR-A- 2 391 588**
**GB-A- 915 393**
**GB-A- 1 128 560**

**ELEKTRONIK, Heft 6, 25. Februar 1983, Seiten 67-71, München, DE; H. FOCH et al.: "DC/AC-Wandler mit hohem Wirkungsgrad"**

(73) Patentinhaber: **Erbe Elektromedizin GmbH.**
**Waldhörnlestrasse 17**
**D-72072 Tübingen(DE)**

(72) Erfinder: **Flachenecker, Gerhard, Prof. Dr.-Ing.**
**Bozener Strasse 2**
**D-8012 Ottobrunn(DE)**
Erfinder: **Lindenmeier, Heinz, Prof. Dr.-Ing.**
**Fürstenrieder Strasse 7**
**D-8033 Planegg(DE)**
Erfinder: **Fastenmeier, Karl, Prof. Dr.-Ing.**
**Pasettiweg 2**
**D-8000 München 83(DE)**

(74) Vertreter: **Endlich, Fritz, Dipl.-Phys.**
**Patentanwalt**
**Postfach 13 26**
**D-82101 Germering (DE)**

**Beschreibung**

Die Erfindung bezieht sich auf einen rückgekoppelten Hochfrequenz-Leistungsoszillator entsprechend dem Oberbegriff des Anspruchs 1.

Für viele industrielle, medizinische oder wissenschaftliche Anwendungen werden hohe Hochfrequenz-Leistungen benötigt. Beispiele aus dem industriellen Bereich sind Trockeneinrichtungen, die mit der Erwärmung eines Materials durch dielektrische Verluste im Hochfrequenzfeld arbeiten oder Schmelzvorrichtungen, bei denen die Erwärmung eines Schmelzgutes über Wirbelströme im Hochfrequenzfeld erfolgt. In der Medizin werden Hochfrequenzleistungen z.B. für die Hochfrequenzchirurgie benötigt und in der Wissenschaft z.B. für die Anregung eines Plasmas in der Spektralanalyse.

Den meisten Anwendungen ist gemeinsam, daß die Belastung des Hochfrequenz-Leistungsgenerators in der Regel nicht konstant ist, sondern oft sehr großen und raschen Änderungen unterworfen ist. Eine weitere Gemeinsamkeit dieser Anwendungen ist die Tatsache, daß der mit der Hochfrequenzleistung zu erzeugende Effekt nicht auf eine sehr strenge Einhaltung der Frequenz angewiesen ist. Darüber hinaus besteht bei allen beschriebenen Anwendungen die Forderung nach einem hohen Wirkungsgrad. Um einen hohen Wirkungsgrad zu erreichen ist es heute üblich, die Verstärkerelemente des Hochfrequenz-Leistungsgenerators, vorzugsweise Transistoren, im Schaltbetrieb zu betreiben. Durch den Schaltbetrieb entstehen Oberwellen im Spektrum der Ausgangsspannung, die viele Nachteile mit sich bringen. Weiterhin entstehen durch die nicht vermeidbaren Streuelemente der Schaltung starke Überschwinger, die die Betriebssicherheit der Verstärkerelemente durch Überspannungen gefährden. Es ist auch bekannt, daß bei Schaltverstärkern wegen der Abschaltverzögerung der Verstärkerelemente nicht beliebig hohe Wirkungsgrade erreicht werden können.

In der Deutschen Patentanmeldung P 38 05 921.5 ist daher ein Hochfrequenz-Leistungsgenerator beschrieben, der mit verschiedenen Maßnahmen versucht, die geschilderten Nachteile zu vermeiden.

Dazu wird ein Leistungsverstärker verwendet, dessen Transistoren als Quasi-Komplementärstufe geschaltet sind und die im Schaltbetrieb arbeiten. Am Ausgang dieses Leistungsverstärkers ist ein Ausgangsfilter angeschlossen, das aus einem in Serie geschalteten Serienresonanzkreis und einem gegen Masse liegenden, also parallel geschalteten Parallelresonanzkreis besteht. Dabei ist der Serienresonanzkreis vom Leistungsverstärker aus gesehen das erste Filterelement. Sowohl der Serienresonanzkreis als auch der Parallelresonanzkreis sind möglichst gut auf die Betriebsfrequenz abgestimmt.

Durch den Serienresonanzkreis wird erreicht, daß der Ausgangsstrom des Leistungsverstärkers nahezu rein sinusförmig verläuft. Der Strom geht dabei nach jeder Halbperiode der Hochfrequenzschwingung durch Null, d.h. genau dann, wenn der Durchlaßzustand jeweils von einem auf den anderen Transistor umgeschaltet wird. Mit dieser Maßnahme werden die Abschaltverluste in den Transistoren besonders klein, weil der Strom im Transistor im Moment des Abschaltens bereits nach Null gegangen war. Abschaltverzögerungen treten dann im Transistor praktisch nicht mehr auf.

Mit dem Parallelresonanzkreis wird erreicht, daß die Ausgangsspannung nahezu rein sinusförmig verläuft. Außerdem kann mit ihm die Lastimpedanz bei der Betriebsfrequenz auf einen reellen Wert gebracht werden, um Phasenverschiebungen zwischen Strom und Spannung sowie Blindströme zu vermeiden.

Um diesen Zustand möglichst exakt einzustellen, werden in der Deutschen Patentanmeldung P 38 05 921.5 verschiedene Maßnahmen vorgeschlagen. Zum Anschwingen wird der Leistungsverstärker zunächst von einem Hilfsgenerator angeregt. Sobald im Verlauf des Anschwingens im Ausgangskreis des Leistungsverstärkers eine deutlich von Null verschiedene Spannung oder ein deutlich von Null verschiedener Strom herrscht, wird auf Selbsterregung, d.h. Oszillatorbetrieb umgeschaltet. Dabei wird die Steuerspannung aus dem den Serienresonanzkreis durchfließenden Strom gewonnen, wenn der Betrag der an den Hochfrequenz-Leistungsgenerator angeschlossenen Lastimpedanz einen charakteristischen Wert unterschreitet, und aus der am Parallelresonanzkreis anliegenden Spannung, wenn die Lastimpedanz diesen charakteristischen Wert überschreitet. Im ersten Fall liegt Stromrückkopplung vor, im zweiten Fall Spannungsrückkopplung.

Der charakteristische Wert der Lastimpedanz ist ein Wert, bei dem der reelle Anteil $R_{Last}$ der Lastimpedanz ungefähr die Bedingung $R_{Last}^2 = L_p/C_s$ erfüllt, wobei $L_p$ die Induktivität des Parallelresonanzkreises und $C_s$ die Kapazität des Serienresonanzkreises ist. Damit wird der Bereich der Lastimpedanz in zwei Bereiche, nämlich einen niederohmigen und einen hochohmigen aufgeteilt. Bei Lastimpedanzen im niederohmigen Bereich wird die Stromrückkopplung verwendet, bei Lastimpedanzen im hochohmigen Bereich die Spannungsrückkopplung.

Die Spannungsrückkopplung zeigt in der Praxis jedoch größere Probleme. Sie wird verwendet, um die Betriebsfrequenz des Hochfrequenz-Leistungsgenerators bei den hochohmigen Lastimpedanzen möglichst genau auf die Resonanzfrequenz des Parallelresonanzkreises zu regeln, damit der Strom durch die Transistoren des Leistungsverstärkers möglichst klein und phasengleich mit der Ausgangsspannung ist. Man stellt in der Praxis jedoch fest, daß dies unter bestimmten Umständen nicht erreicht wird. Sind die Resonanzfrequenzen der beiden Schwingkreise nicht exakt gleich, was z.B. durch Alterung der Bauteile, durch Fehlabgleich der Resonanzkreise oder durch Blindanteile der Lastimpedanz verursacht werden kann, so läuft die Betriebsfrequenz umso näher an die Resonanzfrequenz des Serienresonanzkreises heran, je geringer der Verlustwiderstand des Serienresonanzkreises ist. Aus Gründen des Wirkungsgrades und der Erwärmung des Gerätes wird man aber immer versuchen, den Verlustwiderstand des Serienresonanzkreises so klein wie möglich zu halten. Es kann dann vorkommen, daß der Parallelresonanzkreis weit außerhalb seiner Resonanzfrequenz betrieben wird. Damit steigt sein Blindleitwert und der Leistungsverstärker ist mit einer Impedanz mit deutlicher Blindkomponente belastet. Ausgangsstrom und Ausgangsspannung des Leistungsverstärkers sind dann nicht mehr in Phase, die Verluste in den Transistoren nehmen sehr stark zu und die Betriebssicherheit des Hochfrequenz-Leistungsgenerators ist ernsthaft gefährdet.

Aufgabe der Erfindung ist es daher, einen rückgekoppelten Hochfrequenz-Leistungsoszillator zu schaffen, der die geschilderten Nachteile vermeidet. Diese Aufgabe wird erfindungsgemäß durch den Gegenstand des Anspruchs 1 gelöst. Vorteilhafte Weiterbildungen der Erfindung sind Gegenstand der Unteransprüche.

Bei einem Leistungsoszillator nach der Erfindung wird ein erster Teil der Steuerspannung für den Leistungsverstärker aus der am Parallelresonanzkreis anliegenden Spannung gewonnen, wobei dieser erste Teil Spannungsrückkopplung verursacht. Ein zweiter Teil der Steuerspannung wird aus dem im Serienresonanzkreis fließenden Strom gewonnen, wobei dieser zweite Teil der Steuerspannung Stromgegenkopplung verursacht. Diese beiden Teile der Steuerspannung werden in einem Additionsglied zusammengefaßt und über Impulsformerstufen dem Eingang des Leistungsverstärkers zugeführt. Dadurch entsteht eine gemischte Spannungsrückkopplung und Stromgegenkopplung. Wie später noch gezeigt wird, hat diese gemischte Rückkopplung den Vorteil, daß sich die Betriebsfrequenz bei hochohmigen Lastimpedanzen im Sinne der Deutschen Patentanmeldung P 38 05 921.5 auch bei hoher Güte des Serienresonanzkreises sehr nahe bei der Resonanzfrequenz des Parallelresonanzkreises einstellt. Damit ist der Parallelresonanzkreises sehr gut abgeglichen und sein Blindleitwert ist vernachlässigbar. Die Amplitude des Ausgangsstromes und die Phasenverschiebung zwischen Ausgangsstrom und Ausgangsspannung haben dabei ihre kleinstmöglichen Werte, und der Hochfrequenz-Leistungsoszillator arbeitet mit maximaler Betriebssicherheit. Mit einem erfindungsgemäßen Hochfrequenz-Leistungsoszillator darf daher der Serienresonanzkreis auf Verlustarmut hin optimiert werden, ohne daß dadurch eine Gefährdung für die Betriebssicherheit entstünde.

Die Unterscheidung zwischen Rückkopplung und Gegenkopplung ist im üblichen Sinne zu verstehen. Danach wirkt eine Rückkopplung verstärkend auf die physikalische Größe, aus der die entsprechende Steuerspannung abgeleitet ist, und eine Gegenkopplung abschwächend. Wegen der komplexen Verhältnisse bei einer kombinierten Rück- und Gegenkopplung kann hier aber nicht einfach von "Gleichphasigkeit" und "Gegenphasigkeit" gesprochen werden, wie dies z.B. bei breitbandigen Verstärkern oder bei einfachen Rück- oder Gegenkopplungen möglich wäre. Im folgenden wird daher oft vereinfachend von "Rückkopplung" gesprochen, auch wenn beide Zweige, nämlich die Spannungsrück- und die Stromgegenkopplung gemeint sind.

In einer vorteilhaften Ausgestaltung der Erfindung sind die beiden Zweige der Rückkopplung so dimensioniert, daß für das Verhältnis von Stromgegenkopplung zu Spannungsrückkopplung die Ungleichung

$$R_c/v_u < R_{Lastmin} \qquad (1)$$

erfüllt ist. Darin ist $v_u$ der Konversionsfaktor für den ersten Teil der Steuerspannung bezogen auf den Zweig zwischen der Spannung am Parallelresonanzkreis und dem Additionsglied. $R_c$ ist der Konversionsfaktor für den zweiten Teil der Steuerspannung bezogen auf den Zweig zwischen dem Strom im Serienresonanzkreis und dem Additionsglied.

$R_{Lastmin}$ ist der niedrigste im Betrieb vorkommende Realteil der Lastimpedanz des Hochfrequenz-Leistungsoszillators. Im Falle eines Hochfrequenz-Leistungsgenerators, wie er in der Deutschen Patentanmeldung P 38 05 921.5 beschrieben ist, wäre z.B. wie, oben geschildert, $R_{Lastmin} = \sqrt{L_p/C_s}$.

Mit dieser Maßnahme wird vermieden, daß die Stromgegenkopplung die Spannungsrückkopplung überwiegt, da sonst die Selbsterregung des Hochfrequenz-Leistungsoszillators nicht mehr gewährleistet wäre.

Normalerweise wird unter dem Realteil einer komplexen Impedanz der reelle Anteil verstanden, den man bei einer gedanklich durchgeführten Aufspaltung in eine Serienschaltung aus Real- und Imaginärteil erhält. Im vorliegenden Fall ist die Lastimpedanz einem Parallelresonanzkreis parallel geschaltet. Hier ist es günstiger, die Lastimpedanz gedanklich als Parallelschaltung aus einem Real- und einem Imaginärteil zu

3

verstehen. Dann kann der Imaginärteil sehr einfach dem Parallelresonanzkreis zugeschlagen werden, während der Realteil als reeller Belastungswiderstand parallel zum Parallelresonanzkreis liegt. Hier und im weiteren Verlauf der Beschreibung soll daher als Realteil der Lastimpedanz immer der Realteil verstanden werden, der bei einer gedanklichen Aufspaltung in eine Parallelschaltung aus Real- und Imaginärteil entsteht. Außerdem soll der Imaginärteil der Lastimpedanz dem Parallelresonanzkreis zugeschlagen sein und der Parallel-Verlustwiderstand des Parallelresonanzkreises dem Realteil der Lastimpedanz.

Zur weiteren Verdeutlichung der Erfindung sind noch Zeichnungen beigefügt. Es zeigen:

Fig. 1: Prinzipschaltung eines Hochfrequenz-Leistungsoszillators nach der Erfindung

Fig. 2: Prinzipschaltung eines spannungsrückgekoppelten Hochfrequenz-Leistungsoszillators

Fig. 3: Prinzipschaltung eines spannungsrückgekoppelten Hochfrequenz-Leistungsoszillators mit zusätzlicher Stromgegenkopplung

Fig. 4: Prinzipschaltung eines Hochfrequenz-Leistungsoszillators mit Übertrager zur Impedanzanpassung

Fig. 5: Hochfrequenz-Leistungsoszillator mit widerstandsbelastetem Stromwandler

Fig. 6: Hochfrequenz-Leistungsoszillator mit Stromwandler und Verstärker mit niederohmiger Eingangsimpedanz

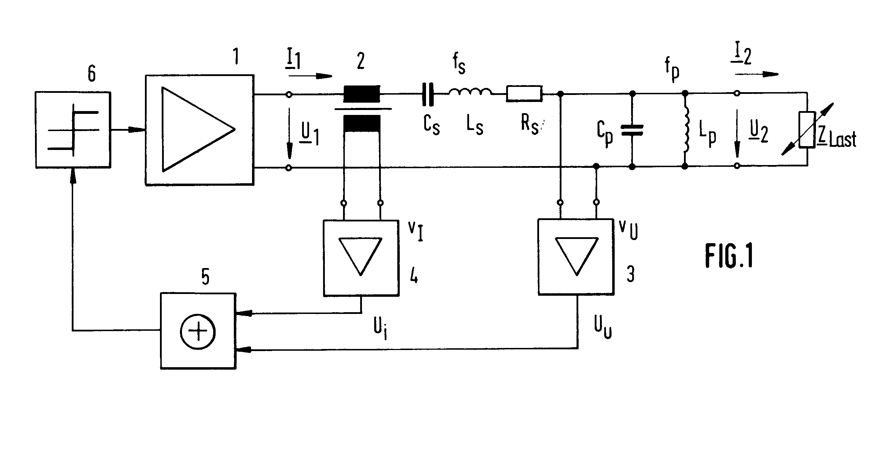

In Fig. 1 ist das Prinzipschaltbild eines Hochfrequenz-Leistungsoszillators nach der Erfindung gezeigt. Dabei ist der Zweig zwischen dem Ausgang des Leistungsverstärkers 1 und der Lastimpedanz $\underline{Z}_{Last}$ in Form von Zweidrahtverbindung gezeichnet, während im übrigen der Signalfluß der Einfachheit halber mit gepfeilten Linien dargestellt ist.

Am Ausgang des Leistungsverstärkers 1 liegt ein Wandlerglied 2, mit dessen Hilfe eine dem Ausgangsstrom $I_1$ proportionale Größe ausgekoppelt werden kann. Darauf folgt ein Serienresonanzkreis, der aus der Induktivität $L_s$ und der Kapazität $C_s$ aufgebaut ist. $R_s$ stellt den Verlustwiderstand des Serienresonanzkreises dar, $f_s$ ist seine Resonanzfrequenz. Auf den Serienresonanzkreis folgt der aus der Induktivität $L_p$ und der Kapazität $C_p$ gebildete Parallelresonanzkreis. $\underline{Z}_{Last}$ ist die an den Hochfrequenz-Leistungsoszillator angeschlossene Lastimpedanz, $f_p$ die resultierende Resonanzfrequenz des Parallelresonanzkreis unter Berücksichtigung der Blindanteile der Lastimpedanz.

Der erste Teil der Steuerspannung für den Leistungsverstärker wird mit dem Wandlerglied 3 aus der am Parallelresonanzkreis anliegenden Spannung abgegriffen. Der zweite Teil der Steuerspannung wird mit dem Koppelglied 4 aus dem Wandlerglied 2 abgenommen. Die beiden Teile der Steuerspannung werden in einem Additionsglied 5 zusammengefaßt und über Impulsformerstufen 6 dem Eingang des Leistungsverstärkers 1 zugeführt.

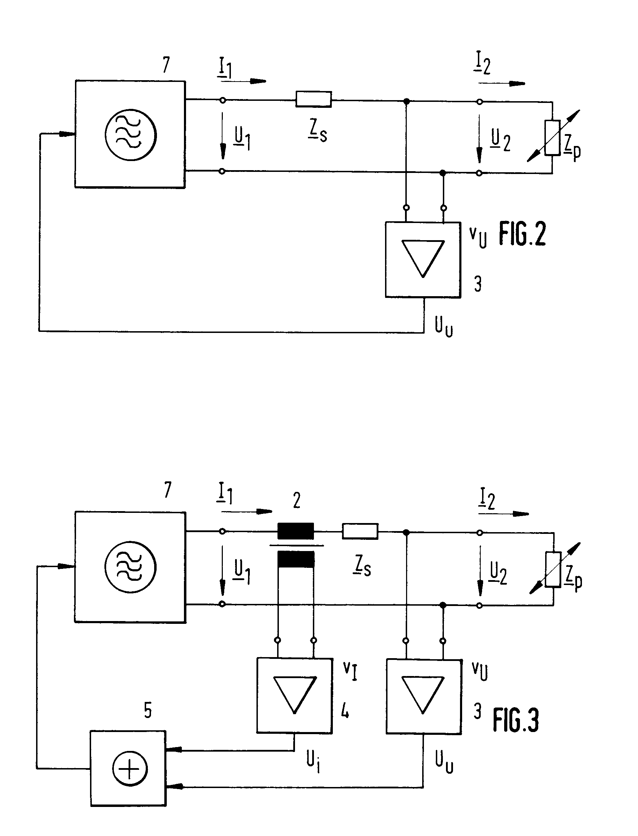

Um die Wirkungsweise der gemischten Spannungsrück- und Stromgegenkopplung näher zu erläutern, wird in Fig. 2 zunächst eine Prinzipschaltung einer einfachen Spannungsrückkopplung ohne die erfindungsgemäße Stromgegenkopplung gezeigt. Der Serienresonanzkreis ist hier durch die Impedanz $\underline{Z}_s$ ausgedrückt und die Parallelschaltung aus Parallelresonanzkreis und Lastimpedanz $\underline{Z}_{Last}$ durch die Impedanz $\underline{Z}_p$. Der Oszillatorverstärker 7 soll die Zusammenfassung des Leistungsverstärkers 1 und der Impulsformerstufe 6 beschreiben.

Die Impulsformerstufe 6 macht wie üblich aus jeder fast beliebig kleinen Eingangsspannung eine rechteckförmige Ausgangsspannung, deren Amplitude für die Aussteuerung des Leistungsverstärkers ausreicht. Die Verstärkung der Impulsformerstufe kann daher als nahezu unendlich angesehen werden. Die im Selbsterregungszustand notwendige Schleifenverstärkung von 1 wird durch die Begrenzereigenschaften des Leistungsverstärkers in Verbindung mit der sehr hohen Verstärkung der Impulsformerstufen 6 automatisch erreicht. Für die Selbsterregung ist daher nur noch die Phasenbedingung zu erfüllen.

Die Phasenbedingung für den Oszillator in Fig. 2 lautet

$$\arg\left\{\frac{\underline{Z}_p}{\underline{Z}_p + \underline{Z}_s}\right\} + \varphi_0 = 0 \qquad (2)$$

Dabei ist $\phi_0$ die Phasenverschiebung, die das Signal im Kopplerzweig 3 und im Oszillatorverstärker 7 erfährt. In der Praxis wird man diese Anteile der Schaltung so dimensionieren, daß $\phi_0$ ungefähr Null ist. Beschreibt man den Serienresonanzkreis durch seine Güte

$$Q_s = \omega L_s / R_s \qquad (3)$$

4

und den Parallelresonanzkreis durch seine Güte

$$Q_p = R_p/\omega L_p \qquad (4)$$

so kann die Betriebsfrequenz f aus Gleichung 2 mit

$$f \approx \sqrt{f_s \cdot f_p} \; \frac{\sqrt{f_s \cdot Q_s + f_p \cdot Q_p}}{\sqrt{f_p \cdot Q_s + f_s \cdot Q_p}}$$

$$(5)$$

berechnet werden. In dieser Gleichung ist zu erkennen, daß die Betriebsfrequenz f sich immer weiter der Resonanzfrequenz $f_s$ des Serienresonanzkreises nähert, je höher die Güte $Q_s$ ist. Bei einer Abweichung der beiden Resonanzfrequenzen $f_p$ und $f_s$ treten dann die beschriebenen Probleme auf.

In Fig. 3 ist analog zu Fig. 2 das vereinfachte Prinzipschaltbild eines Hochfrequenz-Leistungsoszillators nach der Erfindung mit überlagerter Spannungsrückkopplung und Stromgegenkopplung gezeigt. Hier kommt der Stromgegenkopplungspfad mit dem Wandler 2 und dem Koppelglied 4 hinzu. Für diese Schaltung ist die Phasenbedingung für Selbsterregung

$$\arg \left\{ v_u \, \frac{\underline{U}_2}{\underline{U}_1} - R_c \, \frac{\underline{I}_1}{\underline{U}_1} \right\} + \varphi_0 = 0 \qquad (6)$$

wobei $v_u = \underline{U}_u/\underline{U}_2$ der Konversionsfaktor des Koppelgliedes 3 zwischen der Spannung $\underline{U}_2$ am Parallelresonanzkreis und dem Additionsglied 5, und $R_c = \underline{U}_i/I_1$ der Konversionsfaktor des Stromgegenkopplungszweiges zwischen dem Ausgangsstrom $I_1$ des Leistungsverstärkers und dem Additionsglied 5 ist. Nimmt man wieder an, daß die Phasenverschiebung $\phi_0$ im Additionsglied 5 und im Oszillatorverstärker 7 vernachlässigbar klein ist, so kann man Gleichung 6 nach einigen Umformungen wie folgt schreiben:

$$\arg \left\{ \frac{v_u \cdot \underline{Z}_p - R_c}{\underline{Z}_1} \right\} = 0 \qquad (7)$$

Darin ist $\underline{Z}_1 = \underline{U}_1/I_1 = \underline{Z}_s + \underline{Z}_p$ die komplexe Eingangsimpedanz des Ausgangsfilters, die sich dem Leistungsverstärker an seinem Ausgang bietet. Aus Gleichung 7 kann nun wieder die Betriebsfrequenz berechnet werden. Sie ist jetzt

$$f \approx \sqrt{f_s \cdot f_p} \; \frac{\sqrt{f_s \cdot Q_s/p + f_p \cdot Q_p}}{\sqrt{f_p \cdot Q_s/p + f_s \cdot Q_p}}$$

$$(8)$$

Darin ist

$$p = \frac{1 + R_c/(v_u \cdot R_s)}{1 - R_c/(v_u \cdot R_{Last})} \qquad (9)$$

EP 0 351 691 B1

Durch geeignete Wahl von $R_c$ und $v_u$ kann der Wert $p \gg 1$ dimensioniert werden. In diesem Fall wirkt die Güte des Serienresonanzkreises sehr viel schwächer auf die Ausbildung der Betriebsfrequenz f als ohne die Stromgegenkopplung, die Betriebsfrequenz f nähert sich weitgehend der Resonanzfrequenz $f_p$ des Parallelresonanzkreises an. Damit erreicht man die geschilderten Vorteile.

Am Eingang des Additionsgliedes 5 sollte die Spannung aus dem Koppelglied 3 des Spannungsrückkopplungspfades größer sein als die Spannung aus dem Koppelglied 4 des Stromgegenkopplungspfades, damit die Amplitudenbedingung für Selbsterregung erfüllt ist. In einer vorteilhaften Ausgestaltung der Erfindung wird daher das Verhältnis von Stromgegenkopplung zu Spannungsrückkopplung so eingestellt, daß die Ungleichung

$$R_c/v_u < R_{Lastmin} \qquad (10)$$

gilt, wobei $v_u$ der Konversionsfaktor für den ersten Teil der Steuerspannung im Zweig zwischen der Spannung $\underline{U}_2$ am Parallelresonanzkreis und dem Additionsglied 5 und $R_c$ der Konversionsfaktor für den zweiten Teil der Steuerspannung im Zweig zwischen dem Strom $I_1$ im Serienresonanzkreis und dem Additionsglied 5 ist. $R_{Lastmin}$ ist der niedrigste im Betrieb vorkommende Realteil der Lastimpedanz $\underline{Z}_{Last}$.

In vielen Fällen passen die Grenzspannungen und Grenzströme der Transistoren im Leistungsverstärker 1 nicht zum Impedanzniveau der Lastimpedanz $\underline{Z}_{Last}$. In einer weiteren Ausgestaltung der Erfindung ist daher die Induktivität $L_p$ des Parallelresonanzkreises zur Impedanzanpassung der Lastimpedanz an den Leistungsverstärker 1 als Übertrager 8 mit dem Windungszahlenverhältnis

$$w_{primär}:w_{sekundär} = 1:\ddot{u} \qquad (11)$$

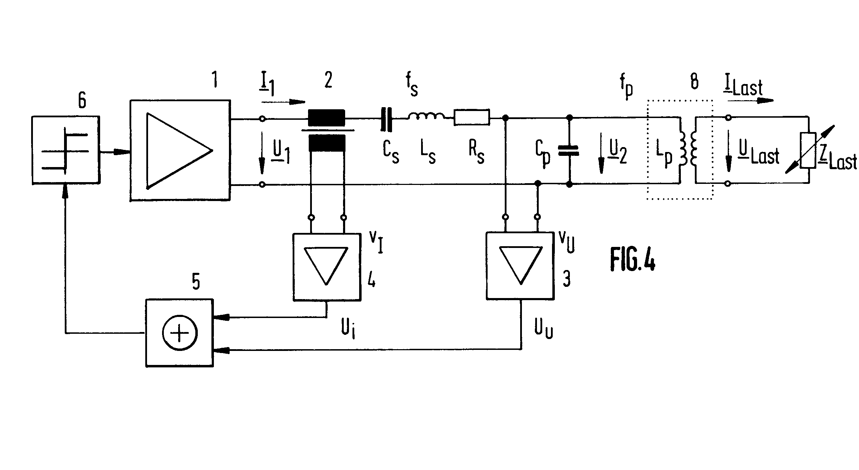

ausgebildet, wobei der Kondensator $C_p$ des Parallelresonanzkreises auf der Primär- und die Lastimpedanz $\underline{Z}_{Last}$ auf der Sekundärseite des Übertragers 8 angeschlossen ist. In Fig. 4 ist die Prinzipschaltung eines solchen Hochfrequenz-Leistungsoszillators mit Übertrager 8 zur Impedanztransformation dargestellt.

In einer weiteren Ausgestaltung der Erfindung ist die Induktivität $L_p$ des Parallelresonanzkreises zur Impedanzanpassung der Lastimpedanz an den Leistungsverstärker 1 ebenfalls als Übertrager 8 mit dem Windungszahlenverhältnis

$$w_{primär}:w_{sekundär} = 1:\ddot{u} \qquad (11)$$

ausgebildet, wobei hier der Kondensator $C_p$ des Parallelresonanzkreises wie die Lastimpedanz auf der Sekundärseite des Übertragers 8 angeschlossen sind. Wegen der Impedanz-Transformation des Übertragers 8 kann dies zu einer besseren Realisierbarkeit des Schwingkreiskondensators $C_p$ führen.

In einer Ausgestaltung, die einen Übertrager 8 verwendet, wird der erste Teil der Steuerspannung an der Primärseite des Übertragers 8 abgegriffen. In diesem Fall wird für das Verhältnis von Stromgegenkopplung zu Spannungsrückkopplung die Erfüllung der Ungleichung

$$R_c/v_u < R_{Lastmin}/\ddot{u}^2 \qquad (12)$$

vorgeschlagen, wobei $v_u$ der Konversionsfaktor für den ersten Teil der Steuerspannung im Zweig zwischen der Spannung $\underline{U}_1$ auf der Primärseite des Übertragers 8 und dem Additionsglied 5, $R_c$ der Konversionsfaktor für den zweiten Teil der Steuerspannung zwischen dem Strom $I_1$ im Serienresonanzkreis und dem Additionsglied 5, $R_{Lastmin}$ der niedrigste im Betrieb vorkommende Realteil der Lastimpedanz $\underline{Z}_{Last}$ und ü das Übersetzungsverhältnis des Übertragers ist.

In einer weiteren Ausgestaltung mit Übertrager 8 zur Impedanzanpassung wird der erste Teil der Steuerspannung an der Sekundärseite des Übertragers 8 abgegriffen und für das Verhältnis von Stromgegenkopplung zu Spannungsrückkopplung wird die Erfüllung der Ungleichung

$$R_c/v_u < R_{Lastmin}/\ddot{u} \qquad (13)$$

vorgeschlagen, wobei $v_u$ der Konversionsfaktor für den ersten Teil der Steuerspannung im Zweig zwischen der Spannung $\underline{U}_{Last}$ auf der Sekundärseite des Übertragers 8 und dem Additionsglied 5, $R_c$ der Konversionsfaktor für den zweiten Teil der Steuerspannung zwischen dem Strom $I_1$ im Serienresonanzkreis und dem Additionsglied, $R_{Lastmin}$ der niedrigste im Betrieb vorkommende Realteil der Lastimpedanz und ü das Übersetzungsverhältnis des Übertragers 8 ist.

6

Das Wandlerglied 3 für die Gewinnung der Spannungsrückkopplung kann ein einfacher Spannungsteiler sein. Es kann auch ein Koppelverstärker oder eine induktive Ankopplung an die Induktivität $L_p$ oder eine kapazitive Teilankopplung an den Kondensator $C_p$ des Parallelresonanzkreises sein.

In weiteren Ausgestaltungen der Erfindung wird der erste Teil der Steuerspannung induktiv aus dem Übertrager 8 oder der Induktivität $L_p$ des Parallelresonanzkreises abgenommen, wobei für das Verhältnis von Stromgegenkopplung zu Spannungsrückkopplung die Erfüllung der Ungleichung

$$R_c/v_u < R_{Lastmin}/ü^2 \qquad (14)$$

vorgeschlagen wird. Darin ist $v_u$ der Konversionsfaktor für den ersten Teil der Steuerspannung im Zweig zwischen der Spannung $\underline{U}_2$ auf der Primärseite des Übertragers 8 oder der Spannung $\underline{U}_2$ an der Induktivität $L_p$ des Parallelresonanzkreises und dem Additionsglied 5, $R_c$ der Konversionsfaktor für den zweiten Teil der Steuerspannung zwischen dem Strom $I_1$ im Serienresonanzkreis und dem Additionsglied 5, $R_{Lastmin}$ der niedrigste im Betrieb vorkommende Realteil der Lastimpedanz $\underline{Z}_{Last}$ und ü das Übersetzungsverhältnis des Übertragers 8. Im Fall einer einfachen Induktivität $L_p$ ist in Gleichung 12 ü = 1 zu setzen.

In einer weiteren Ausgestaltung der Erfindung wird vorgeschlagen, den zweiten Teil der Steuerspannung mit Hilfe eines Stromwandlers 2 zu gewinnen, dessen Primärwicklung in einer der beiden Ausgangsleitungen des Leistungsverstärkers 1 liegt und dessen Sekundärwicklung mit einem Widerstand belastet ist, dessen Wert im Betriebsfrequenzbereich sehr viel kleiner, d.h. um mindestens eine Größenordnung kleiner als der induktive Widerstand der Sekundärwicklung des Stromwandlers 2 ist, wobei der zweite Teil der Steuerspannung an diesem Widerstand abgegriffen wird. Man erreicht damit eine ausreichend phasenreine Konversion des Stromes $I_1$ in eine für die Stromgegenkopplung geeignete Spannung.

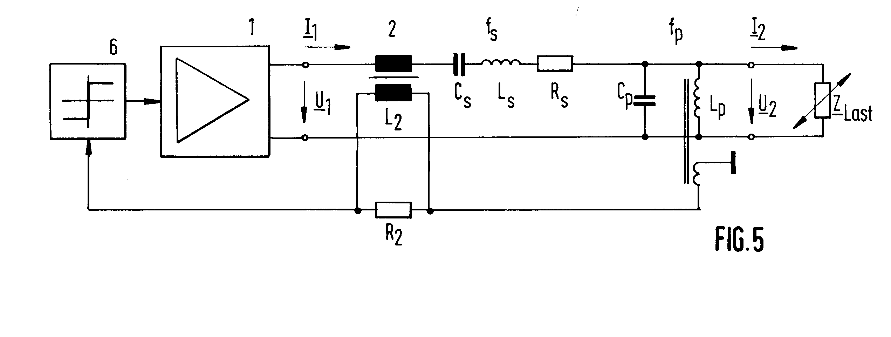

In Fig. 5 ist ein Prinzipschaltbild gezeigt, in welchem die induktive Auskopplung des ersten Teils der Steuerspannung durch induktive Auskopplung aus der Induktivität $L_p$ des Parallelresonanzkreises verwendet wird. Weiterhin wird in diesem Beispiel ein Stromwandler 2 mit einem sekundärseitigen Widerstand $R_2$ angewandt. Man sieht, daß die beiden Maßnahmen zu einer besonders einfachen Addition der beiden Anteile der Steuerspannung führen. Ein eigenes Additionsglied 5 ist hier nicht mehr nötig.

In einer weiteren Ausgestaltung der Erfindung wird der erste Teil der Steuerspannung durch kapazitive Teilankopplung aus der Kapazität ($C_p$) des Parallelresonanzkreises abgenommen.

In einer weiteren Ausgestaltung der Erfindung wird der zweite Teil der Steuerspannung mit Hilfe eines Stromwandlers 2 gewonnen, dessen Primärwicklung in einer der beiden Ausgangsleitungen des Leistungsverstärkers 1 liegt und an dessen Sekundärwicklung ein Verstärker angeschlossen ist, dessen Eingangsimpedanz im Betriebsfrequenzbereich sehr viel kleiner, d.h. um mindestens eine Größenordnung kleiner als der induktive Widerstand der Sekundärwicklung des Stromwandlers ist. Der zweite Teil der Steuerspannung wird am Ausgang dieses Verstärkers abgegriffen.

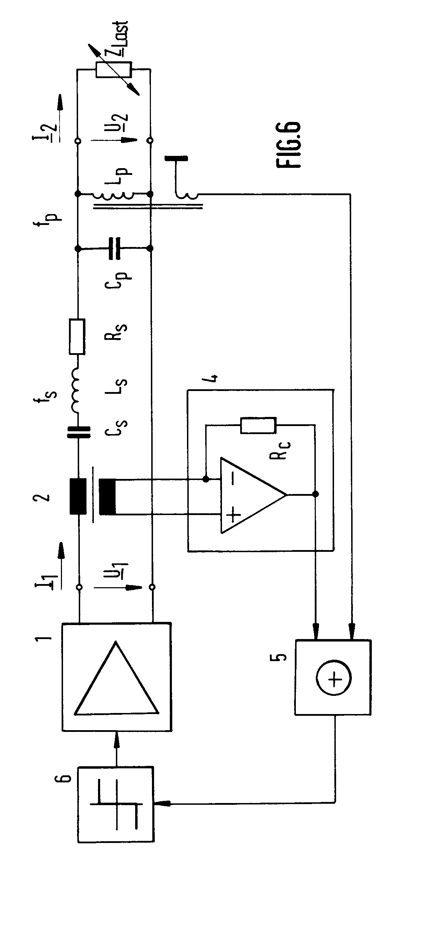

In einer besonders vorteilhaften Anordnung wird im Koppelglied 4 ein spannungsgegengekoppelter Operationsverstärker als Verstärker verwendet, wie in Fig. 6 dargestellt ist.

In einer besonders einfachen Ausführung kann als Wandlerglied 2 in an sich bekannter Weise auch ein ohm'scher Widerstand verwendet werden. In diesem Fall ist allerdings auf entsprechende Potentialtrennung zur Elektronik des Rückkopplungszweiges zu achten.

## Patentansprüche

1. Rückgekoppelter Hochfrequenz-Leistungsoszillator mit einem als Komplementär- oder Quasikomplementär-Stufe aufgebauten, im Schaltbetrieb arbeitenden Leistungsverstärker, und einem Ausgangsfilter, welches einen ungefähr auf die mittlere Betriebsfrequenz abgestimmten in Serie geschalteten Serienresonanzkreis und einen ungefähr auf die mittlere Betriebsfrequenz abgestimmten parallel geschalteten Parallelresonanzkreis enthält, wobei der Serienresonanzkreis vom Leistungsverstärker aus gesehen das erste Filterelement darstellt, und die Steuerspannung für den Leistungsverstärker durch Rückkopplung aus dem Ausgangsfilter gewonnen wird, dadurch gekennzeichnet, daß
   - ein erster Teil der Steuerspannung für den Leistungsverstärker (1) aus der am Parallelresonanzkreis ($L_p$, $C_p$) anliegenden Spannung gewonnen wird, wobei dieser erste Teil Spannungsrückkopplung verursacht,
   - ein zweiter Teil der Steuerspannung für den Leistungsverstärker (1) aus dem im Serienresonanzkreis ($L_s$, $C_s$) fließenden Strom gewonnen wird, wobei dieser zweite Teil der Steuerspannung Stromgegenkopplung verursacht
   und diese beiden Teile der Steuerspannung in einem Additionsglied (5) zusammengefaßt und über Impulsformerstufen (6) dem Eingang des Leistungsverstärker (1) zugeführt werden.

**2.** Rückgekoppelter Hochfrequenz-Leistungsoszillator nach Anspruch 1, dadurch gekennzeichnet, daß das Verhältnis von Stromgegenkopplung zu Spannungsrückkopplung so dimensioniert ist, daß die Ungleichung

$R_c/v_u < R_{Lastmin}$

erfüllt ist, wobei $v_u$ der Konversionsfaktor für den ersten Teil der Steuerspannung im Zweig zwischen der Spannung ($\underline{U}_2$) am Parallelresonanzkreis ($L_p$, $C_p$) und dem Additionsglied (5), $R_c$ der Konversionsfaktor für den zweiten Teil der Steuerspannung im Zeig zwischen dem Strom ($\underline{I}_1$) im Serienresonanzkreis ($L_s$, $C_s$) und dem Additionsglied (5) und $R_{Lastmin}$ der niedrigste im Betrieb vorkommende Realteil der Lastimpedanz ($\underline{Z}_{Last}$) ist, wobei die Lastimpedanz ($\underline{Z}_{Last}$) als Parallelschaltung eines Real-und eines Imaginärteiles aufgefaßt wird.

**3.** Rückgekoppelter Hochfrequenz-Leistungsoszillator nach Anspruch 1, dadurch gekennzeichnet, daß die Induktivität ($L_p$) des Parallelresonanzkreises zur Impedanzanpassung der Lastimpedanz ($\underline{Z}_{Last}$) an den Leistungsverstärker (1) als Übertrager (8) mit dem Windungszahlenverhältnis

$w_{primär}:w_{sekundär} = 1:\ddot{u}$

ausgebildet ist, wobei der Kondensator ($C_p$) des Parallelresonanzkreises auf der Primär- und die Lastimpedanz ($\underline{Z}_{Last}$) auf der Sekundärseite des Übertragers (8) angeschlossen ist.

**4.** Rückgekoppelter Hochfrequenz-Leistungsoszillator nach Anspruch 1, dadurch gekennzeichnet, daß die Induktivität ($L_p$) des Parallelresonanzkreises zur Impedanzanpassung der Lastimpedanz ($\underline{Z}_{Last}$) an den Leistungsverstärker (1) als Übertrager (8) mit dem Windungszahlenverhältnis

$w_{primär}:w_{sekundär} = 1:\ddot{u}$

ausgebildet ist, wobei der Kondensator ($C_p$) des Parallelresonanzkreises und der Lastimpedanz ($\underline{Z}_{Last}$) auf der Sekundärseite des Übertragers (8) angeschlossen sind.

**5.** Rückgekoppelter Hochfrequenz-Leistungsoszillator nach Anspruch 3 oder 4, dadurch gekennzeichnet, daß der erste Teil der Steuerspannung an der Primärseite des Übertragers (8) abgegriffen wird und das Verhältnis von Stromgegenkopplung zu Spannungsrückkopplung so dimensioniert ist, daß die Ungleichung

$R_c/v_u < R_{Lastmin}/\ddot{u}^2$

erfüllt ist, wobei $v_u$ der Konversionsfaktor für den ersten Teil der Steuerspannung im Zweig zwischen der Spannung ($\underline{U}_2$) auf der Primärseite des Übertragers (8) und dem Additionsglied (5), $R_c$ der Konversionsfaktor für den zweiten Teil der Steuerspannung im Zweig zwischen dem Strom ($\underline{I}_1$) im Serienresonanzkreis ($L_s$, $C_s$) und dem Additionsglied (5), $\ddot{u}$ das Übersetzungsverhältnis des Übertragers (8) und $R_{Lastmin}$ der niedrigste im Betrieb vorkommende Realteil der Lastimpedanz ($\underline{Z}_{Last}$) ist, wobei die Lastimpedanz ($\underline{Z}_{Last}$) als Parallelschaltung eines Real- und eines Imaginärteiles aufgefaßt wird.

**6.** Rückgekoppelter Hochfrequenz-Leistungsoszillator nach Anspruch 3 oder 4, dadurch gekennzeichnet, daß der erste Teil der Steuerspannung an der Sekundärseite des Übertragers (8) abgegriffen wird und das Verhältnis von Stromgegenkopplung zu Spannungsrückkopplung so dimensioniert ist, daß die Ungleichung

$R_c/v_u < R_{Lastmin}/\ddot{u}$

erfüllt ist, wobei $v_u$ der Konversionsfaktor für den ersten Teil der Steuerspannung im Zweig zwischen der Spannung ($\underline{U}_{Last}$) auf der Sekundärseite des Übertragers (8) und dem Additionsglied (5), $R_c$ der Konversionsfaktor für den zweiten Teil der Steuerspannung im Zweig zwischen dem Strom ($\underline{I}_1$) im Serienresonanzkreis ($L_s$, $C_s$) und dem Additionsglied (5), $\ddot{u}$ das Übersetzungsverhältnis des Übertragers

EP 0 351 691 B1

und $R_{Lastmin}$ der niedrigste im Betrieb vorkommende Realteil der Lastimpedanz ($\underline{Z}_{Last}$) ist, wobei die Lastimpedanz ($\underline{Z}_{Last}$) als Parallelschaltung eines Real- und eines Imaginärteiles aufgefaßt wird.

7. Rückgekoppelter Hochfrequenz-Leistungsoszillator nach Anspruch 1 oder 2, dadurch gekennzeichnet, daß
der erste Teil der Steuerspannung induktiv aus der Induktivität ($L_p$) abgenommen wird.

8. Rückgekoppelter Hochfrequenz-Leistungsoszillator nach Anspruch 1 bis 6, dadurch gekennzeichnet, daß
der erste Teil der Steuerspannung durch kapazitive Teilankopplung aus der Kapazität ($C_p$) des Parallelresonanzkreises abgenommen wird.

9. Rückgekoppelter Hochfrequenz-Leistungsoszillator nach Anspruch 3 bis 6, dadurch gekennzeichnet, daß
der erste Teil der Steuerspannung induktiv aus dem Übertrager (8) abgenommen wird.

10. Rückgekoppelter Hochfrequenz-Leistungsoszillator nach Anspruch 1 bis 9, dadurch gekennzeichnet, daß
der zweite Teil der Steuerspannung mit Hilfe eines Stromwandlers (2) gewonnen wird, dessen Primärwicklung in einer der beiden Ausgangsleitungen des Leistungsverstärkers (1) liegt und dessen Sekundärwicklung mit einem Widerstand ($R_2$) belastet ist, dessen Wert im Betriebsfrequenzbereich sehr viel kleiner, d.h. um mindestens eine Größenordnung kleiner als der induktive Widerstand der Sekundärwicklung des Stromwandlers (2) ist, und der zweite Teil der Steuerspannung an diesem Widerstand ($R_2$) abgegriffen wird.

11. Rückgekoppelter Hochfrequenz-Leistungsoszillator nach Anspruch 1 bis 9, dadurch gekennzeichnet, daß
der zweite Teil der Steuerspannung mit Hilfe eines Stromwandlers (2) gewonnen wird, dessen Primärwicklung in einer der beiden Ausgangsleitungen des Leistungsverstärkers (1) liegt und an dessen Sekundärwicklung ein Verstärker (4) angeschlossen ist, dessen Eingangsimpedanz im Betriebsfrequenzbereich sehr viel kleiner, d.h. um mindestens eine Größenordnung kleiner als der induktive Widerstand der Sekundärwicklung des Stromwandlers ist, und der zweite Teil der Steuerspannung am Ausgang dieses Verstärkers (4) abgegriffen wird.

12. Rückgekoppelter Hochfrequenz-Leistungsoszillator nach Anspruch 11, dadurch gekennzeichnet, daß der Verstärker (4) als spannungsgegengekoppelter Operationsverstärker ausgeführt ist.

13. Rückgekoppelter Hochfrequenz-Leistungsoszillator nach Anspruch 1 bis 9, dadurch gekennzeichnet, daß
der zweite Teil der Steuerspannung mit Hilfe eines ohm'schen Widerstandes gewonnen wird, der in einer der beiden Ausgangsleitungen des Leistungsverstärkers (1) liegt.

## Claims

1. A high frequency power oscillator with feedback with a power amplifier designed as a complementary stage or a quasi-complementary stage operating in a switching mode, and with an output filter comprising a series resonant circuit placed in series, tuned approximately to the mean operating frequency, and a parallel resonant circuit placed in parallel, tuned approximately to the mean operating frequency, the series resonant circuit constituting the first filter element viewed from the power amplifier, and the control voltage for the power amplifier being obtained by feedback from the output filter, characterized in that
   - a first part of the control voltage for the power amplifier (1) is taken from the voltage obtaining in the parallel resonant circuit ($L_p$, $C_p$), this first part causing a voltage feedback,
   - a second part of the control voltage for the power amplifier (1) being obtained from the current flowing in the series resonant circuit ($L_s$, $C_s$), this second part of the control voltage causing a current feedback
   and these two parts of the control voltage being combined in an adder element (5) and being passed to the input of the power amplifier (1) via pulse shaping stages (6).

9

**2.** A high frequency power oscillator with feedback according to claim 1, characterized in that the current feedback/voltage feedback ratio is rated in such a way that the inequality

$$R_c / v_u < R_{load\ min}$$

is met, $v_u$ being the conversion factor for the first part of the control voltage in the branch between the voltage ($\underline{U}_2$) in the parallel resonant circuit ($L_p$, $C_p$) and the adder element (5), $R_c$ being the conversion factor for the second part of the control voltage in the branch between the current ($\underline{I}_1$) in the series resonant circuit ($L_s$, $C_s$) and the adder element (5), and $R_{load\ min}$ being the lowest real component of the load impedance ($\underline{Z}_{load}$) occurring in operation, the load impedance ($\underline{Z}_{load}$) being conceived as a parallel connection of a real and an imaginary component.

**3.** A high frequency power oscillator with feedback according to claim 1 characterized in that the inductance ($L_p$) of the parallel resonant circuit for the impedance matching of the load impedance ($\underline{Z}_{load}$) to the power amplifier (1) is designed as the transformer (8) with the turns ratio of

$$w_{primary} : w_{secondary} = 1 : ü$$

the capacitor ($C_p$) of the parallel resonant circuit being connected on the primary side and the load impedance ($\underline{Z}_{load}$) on the secondary side of the transformer (8).

**4.** A high frequency power oscillator with feedback according to claim 1, characterized in that the inductance ($L_p$) of the parallel resonant circuit for the impedance matching of the load impedance ($\underline{Z}_{load}$) to the power amplifier (1) is designed as the transformer (8) with the turns ratio of

$$w_{primary} : w_{secondary} = 1 : ü$$

the capacitor ($C_p$) of the parallel resonant circuit and of the load impedance ($\underline{Z}_{load}$) being connected on the secondary side of the transformer (8).

**5.** A high frequency power oscillator with feedback according to claim 3 or 4, characterized in that the first part of the control voltage is tapped on the primary side of the transformer (8) and in that the current feedback / voltage feedback ratio is rated in such a way that the inequality

$$R_c / v_u < R_{load\ min}/ü^2$$

is met, $v_u$ being the conversion factor for the first part of the control voltage in the branch between the voltage ($\underline{U}_2$) on the primary side of the transformer (8) and the adder element (5), $R_c$ being the conversion factor for the second part of the control voltage in the branch between the current ($\underline{I}_1$) in the series resonant circuit ($L_s$, $C_s$) and the adder element (5), ü being the turns ratio of the transformer (8) and $R_{load\ min}$ being the lowest real component of the load impedance ($\underline{Z}_{load}$) occurring in operation, the load impedance ($\underline{Z}_{load}$) being conceived as a parallel connection of a real and an imaginary component.

**6.** A high frequency power oscillator with feedback according to claim 3 or 4, characterized in that the first part of the control voltage is tapped on the secondary side of the transformer (8) and in that the current feedback/voltage feedback ratio is rated in such a way that the inequality

$$R_c / v_u < R_{load\ min}/ü$$

is met, $v_u$ being the conversion factor for the first part of the control voltage in the branch between the voltage ($\underline{U}_{load}$) on the secondary side of the transformer (8) and the adder element (5), $R_c$ being the conversion factor for the second part of the control voltage in the branch between the current ($\underline{I}_1$) in the series resonant circuit ($L_s$, $C_s$) and the adder element (5), ü being the turns ratio of the transformer and $R_{load\ min}$ being the lowest real component of the load impedance ($\underline{Z}_{load}$) occurring in operation, the load impedance ($\underline{Z}_{load}$) being conceived as a parallel connection of a real and an imaginary component.

**7.** A high frequency power oscillator with feedback according to claim 1 or 2, characterized in that the first part of the control voltage is tapped inductively from the inductance ($L_p$).

**8.** A high frequency power oscillator with feedback according to claims 1 to 6, characterized in that the first part of the control voltage is tapped by capacitive part coupling from the capacitor ($C_p$) of the parallel resonant circuit.

**9.** A high frequency power oscIllator with feedback according to claims 3 to 6, characterized in that the first part of the control voltage is tapped inductively from the transformer (8).

**10.** A high frequency power oscillator with feedback according to claims 1 to 9, characterized in that the second part of the control voltage is obtained by means of a current transformer (2) whose primary winding lies in one of the two output lines of the power amplifier (1), and whose secondary winding is loaded by a resistor ($R_2$) whose value in the operating frequency range is very much smaller, that is to say, by at least one order, than the inductive resistance of the secondary winding of the current transformer (2), and in that the second part of the control voltage is tapped at this resistor ($R_2$).

**11.** A high frequency power oscillator with feedback according to claims 1 to 9, characterized in that the second part of the control voltage is obtained by means of a current transformer (2) whose primary winding lies in one of the two output lines of the power amplifier (1) and to whose secondary winding there is connected an amplifier (4) whose input impedance in the operating frequency range is very much smaller, that is to say, by at least one order, than the inductive resistance of the secondary winding of the current transformer, and in that the second part of the control voltage is tapped at the output of this amplifier (4).

**12.** A high frequency power oscillator with feedback according to claim 11, characterized in that the amplifier (4) is designed as an operational amplifier with voltage feedback.

**13.** A high frequency power oscillator with feedback according to claims 1 to 9, characterized in that the second part of the control voltage is obtained by means of an ohmic resistor situated in one of the two output lines of the power amplifier (1).

## Revendications

**1.** Oscillateur de puissance à haute fréquence à contre-réaction, avec un amplificateur de puissance construit comme étage complémentaire ou quasi-complémentaire, travaillant en opération intermittente, et un filtre de sortie qui contient un circuit de résonance série réglé à peu près à la fréquence moyenne de fonctionnement et branché en série, et qui contient un circuit de résonance parallèle réglé à peu près à la fréquence moyenne de fonctionnement et branché en parallèle, le circuit de résonance série constituant le premier élément de filtre, les choses étant vues depuis l'amplificateur de puissance, et la tension de commande pour l'amplificateur de puissance étant obtenue par bouclage de réaction à partir du filtre de sortie, caractérisé en ce qu'
   - une première partie de la tension de commande pour l'amplificateur de puissance (1) est obtenue à partir de la tension appliquée sur le circuit de résonance parallèle ($L_p,C_p$), cette première partie provoquant le bouclage de réaction en tension,
   - une deuxième partie de la tension de commande pour l'amplificateur de puissance (1) est obtenue à partir de l'intensité du courant s'écoulant dans le circuit de résonance série ($L_s,C_s$), cette deuxième partie de la tension de commande provoquant le bouclage de contre-réaction en intensité,

   et ces deux parties de la tension de commande étant groupées dans un composant d'addition (5) et amenées par des étages formateurs d'impulsions (6) à l'entrée de l'amplificateur de puissance (1).

**2.** Oscillateur de puissance à haute fréquence à contre-réaction selon la revendication 1, caractérisé en ce que le rapport entre contre-couplage en intensité et contre-réaction en tension est tel que l'inégalité

$$R_c/V_u < R_{chargemin}$$

est remplie, $V_u$ étant le facteur de conversion pour la première partie de la tension de commande dans la branche située entre la tension ($\underline{U}_2$) sur le circuit de résonance parallèle ($L_p,C_p$) et le composant d'addition (5), $R_c$ étant le facteur de conversion pour la deuxième partie de la tension de commande dans la banche située entre l'intensité ($\underline{I}_1$) dans le circuit de résonance série ($L_s,C_s$) et le composant

d'addition (5) et $R_{chargemin}$ étant la partie réelle la plus faible qui se manifeste en fonctionnement de l'impédance de charge ($\underline{Z}_{charge}$), l'impédance de charge ($\underline{Z}_{charge}$) étant considérée comme le branchement en parallèle d'une partie réelle et d'une partie imaginaire.

3. Oscillateur de puissance à haute fréquence à contre-réaction selon la revendication 1, caractérisé en ce qu'en vue de l'adaptation d'impédance de l'impédance de charge ($\underline{Z}_{charge}$) à l'amplificateur de puissance (1), l'inductance ($L_p$) du circuit de résonance parallèle est réalisée comme un transformateur (8) avec le rapport de nombres de spires

$$w_{primaire}{:}w_{secondaire} = 1{:}\ddot{u},$$

le condensateur ($C_p$) du circuit de résonance parallèle étant raccordé au côté du primaire du transformateur (8) et l'impédance de charge ($\underline{Z}_{charge}$) étant raccordée au côté du secondaire.

4. Oscillateur de puissance à haute fréquence à contre-réaction selon la revendication 1, caractérisé en ce qu'en vue de l'adaptation d'impédance de l'impédance de charge ($\underline{Z}_{charge}$) à l'amplificateur de puissance (1), l'inductance ($L_p$) du circuit de résonance parallèle est réalisée comme un transformateur (8) avec le rapport de nombres de spires

$$w_{primaire}{:}w_{secondaire} = 1{:}\ddot{u},$$

le condensateur ($C_p$) du circuit de résonance parallèle et
l'impédance de charge ($\underline{Z}_{charge}$) étant raccordés au côté du secondaire du transformateur (8).

5. Oscillateur de puissance à haute fréquence à contre-réaction selon la revendication 3 ou 4, caractérisé en ce que la première partie de la tension de commande est prélevée sur le côté du primaire du transformateur (8) et que le rapport entre contre-couplage en intensité et contre-réaction en tension est tel que l'inégalité

$$R_c/V_u < R_{chargemin}\,/u^2$$

est remplie, $V_u$ étant le facteur de conversion pour la première partie de la tension de commande dans la branche située entre la tension ($\underline{U}_2$) du côté du primaire du transformateur (8) et le composant d'addition (5), $R_c$ étant le facteur de conversion pour la deuxième partie de la tension de commande dans la banche située entre l'intensité ($I_1$) dans le circuit de résonance série ($L_s,C_s$) et le composant d'addition (5), $\ddot{u}$ étant le rapport de transformation du transformateur (8) et $R_{chargemin}$ étant la partie réelle la plus faible qui se manifeste en fonctionnement de l'impédance de charge ($\underline{Z}_{charge}$), l'impédance de charge ($\underline{Z}_{charge}$) étant considérée comme le branchement en parallèle d'une partie réelle et d'une partie imaginaire.

6. Oscillateur de puissance à haute fréquence à contre-réaction selon la revendication 3 ou 4, caractérisé en ce que la première partie de la tension de commande est prélevée sur le côté du secondaire du transformateur (8) et que le rapport entre contre-couplage en intensité et contre-réaction en tension est tel que l'inégalité

$$R_c/V_u < R_{chargemin}\,/\ddot{u}$$

est remplie, $V_u$ étant le facteur de conversion pour la première partie de la tension de commande dans la branche située entre la tension ($\underline{U}_{charge}$) du côté du secondaire du transformateur (8) et le composant d'addition (5), $R_c$ étant le facteur de conversion pour la deuxième partie de la tension de commande dans la banche située entre l'intensité ($I_1$) dans le circuit de résonance série ($L_s,C_s$) et le composant d'addition (5), $\ddot{u}$ étant le rapport de transformation du transformateur et $R_{chargemin}$ étant la partie réelle la plus faible qui se manifeste en fonctionnement de l'impédance de charge ($\underline{Z}_{charge}$), l'impédance de charge ($\underline{Z}_{charge}$) étant considérée comme le branchement en parallèle d'une partie réelle et d'une partie imaginaire.

7. Oscillateur de puissance à haute fréquence à contre-réaction selon la revendication 1 ou 2, caractérisé en ce que la première partie de la tension de commande est prélevée de manière inductive à partir de

l'inductance ($L_p$).

8. Oscillateur de puissance à haute fréquence à contre-réaction selon les revendications 1 à 6, caractérisé en ce que la première partie de la tension de commande est prélevée par couplage partiel capacitif à partir de la capacité ($C_p$) du circuit de résonance parallèle.

9. Oscillateur de puissance à haute fréquence à contre-réaction selon les revendications 3 à 6, caractérisé en ce que la première partie de la tension de commande est prélevée de manière inductive à partir du transformateur (8).

10. Oscillateur de puissance à haute fréquence à contre-réaction selon les revendications 1 à 9, caractérisé en ce que la seconde partie de la tension de commande est obtenue à l'aide d'un transformateur d'intensité (2) dont l'enroulement primaire est situé dans l'une des deux lignes de sorties de l'amplificateur de puissance (1) et dont l'enroulement secondaire est pourvu d'une résistance ($R_2$) dont la valeur, dans la plage de fréquence de fonctionnement, est beaucoup plus petite, c'est-à-dire d'au moins un ordre de grandeur, que la résistance inductive de l'enroulement secondaire du transformateur d'intensité (2) et la deuxième partie de la tension de commande étant prélevée sur cette résistance ($R_2$).

11. Oscillateur de puissance à haute fréquence à contre-réaction selon les revendications 1 à 9, caractérisé en ce que la seconde partie de la tension de commande est obtenue à l'aide d'un transformateur d'intensité (2) dont l'enroulement primaire est situé dans l'une des deux lignes de sorties de l'amplificateur de puissance (1) et à l'enroulement secondaire duquel est raccordé un amplificateur (4) dont l'impédance d'entrée, dans la plage de fréquence de fonctionnement, est beaucoup plus petite, c'est-à-dire d'au moins un ordre de grandeur, que la résistance inductive de l'enroulement secondaire du transformateur d'intensité (2) et la deuxième partie de la tension de commande étant prélevée à la sortie de cet amplificateur (4).

12. Oscillateur de puissance à haute fréquence à contre-réaction selon la revendication 11, caractérisé en ce que l'amplificateur (4) est réalisé sous la forme d'un amplificateur opérationnel à contre-réaction en tension.

13. Oscillateur de puissance à haute fréquence à contre-réaction selon les revendications 1 à 9, caractérisé en ce que la deuxième partie de la tension de commande est obtenue à l'aide d'une résistance ohmique qui est placées dans l'une des deux lignes de sortie de l'amplificateur de puissance (1).

FIG.1

FIG.2

FIG.3

FIG.4

FIG.5

FIG.6